# FASCICULE DE BREVET EUROPEEN

(11) **EP 3 163 758 B1**
(45) Date de publication et mention de la délivrance du brevet: **30.06.2021**
(21) Numéro de dépôt: 16196186.7
(22) Date de dépôt: 28.10.2016
(51) Int. Cl.: H04B 1/28, H03J 1/00, H04B 1/18, H04W 52/02

(54) **DISPOSITIF RÉCEPTEUR DE SIGNAUX RADIOFRÉQUENCE, PROCÉDÉ DE RÉGLAGE POUR UN TEL DISPOSITIF ET PROGRAMME D'ORDINATEUR CORRESPONDANT**
EMPFANGSGERÄT VON FUNKSIGNALEN, VERFAHREN ZUR EINSTELLUNG EINES SOLCHEN GERÄTS UND ENTSPRECHENDES COMPUTERPROGRAMM
RADIO FREQUENCY SIGNAL RECEIVER DEVICE, CONTROL METHOD FOR SUCH A DEVICE AND CORRESPONDING COMPUTER PROGRAM

(30) Priorité: 02.11.2015 FR 1560480
(43) Date de publication de la demande: 03.05.2017
(73) Titulaire: Commissariat à l'Énergie Atomique et aux Énergies Alternatives, 75015 Paris (FR)
(72) Inventeur: MARTINEAU, Baudouin, 38570 Tencin (FR); JANY, Clément, 38100 Grenoble (FR)
(74) Mandataire: Bonnet, Michel

(56) Documents cités:
- US-A1- 2010 197 256

## Description

La présente invention concerne un dispositif récepteur de signaux radiofréquence. Elle concerne également un procédé de réglage pour un tel dispositif et un programme d'ordinateur correspondant.

L'invention s'applique plus particulièrement à un dispositif récepteur de signaux radiofréquence comportant :
- un oscillateur local oscillant à une fréquence locale réglable,
- un mélangeur recevant les signaux radiofréquence et la sortie de l'oscillateur local pour la fourniture de signaux à fréquence intermédiaire,
- un système de filtrage, passe-bas ou passe-bande, configuré et placé pour filtrer les signaux à fréquence intermédiaire ou radiofréquence selon une bande passante de largeur fréquentielle réglable, et
- un détecteur de données dans les signaux à fréquence intermédiaire.

Une telle architecture est propre aux récepteurs hétérodynes qui utilisent un oscillateur local pour transposer les signaux radiofréquence autour d'une fréquence, dite intermédiaire, très faible devant leur fréquence porteuse initiale, avant de détecter les données qu'ils contiennent en les ramenant si nécessaire, lorsque la fréquence intermédiaire n'est pas nulle, en bande de base. En environnement spectral encombré, ces récepteurs nécessitent une génération très précise de fréquence locale et une grande sélectivité en fréquences pour atteindre une sensibilité satisfaisante. Il est ainsi généralement connu de concevoir l'oscillateur local d'un dispositif récepteur à architecture hétérodyne sous la forme d'une boucle à verrouillage de phase utilisant un résonateur à très fort coefficient de qualité, généralement un résonateur à quartz. Il est également connu de prévoir un système de filtrage à bande passante étroite et à grand facteur de qualité.

Cependant, de tels choix technologiques conviennent mal à la réalisation d'un dispositif récepteur à ultra faible consommation, c'est-à-dire un récepteur consommant aujourd'hui moins d'un milliwatt. Ils ne conviennent pas non plus pour un dispositif récepteur destiné à s'activer de façon sporadique au cours de cycles prédéterminés courts, comme il en existe dans le domaine des récepteurs à ultra faible consommation, car le temps d'établissement du régime permanent d'une boucle à verrouillage de phase est d'autant plus long qu'elle est précise, surtout lorsqu'elle comporte un résonateur à quartz. Il dépasse donc généralement la longueur des cycles. Une autre difficulté est liée aux coûts. En effet, ces choix technologiques imposent de nombreuses inductances à différents niveaux de la chaîne de traitement des signaux reçus. Or les inductances sont des composants électroniques encombrants engendrant un surcoût important.

Par exemple, l'architecture proposée dans l'article de Pletcher et al, intitulé « A 2GHz 52µW wake-up receiver with -72dBm sensitivity using uncertain-IF architecture », publié dans IEEE ISSCC Dig. Tech. Papers, pp. 524-526, février 2008, présente un oscillateur local qualifié de libre mais qui nécessite malgré tout un recalibrage régulier, notamment au démarrage, pour pallier son manque de précision.

Par exemple également, l'architecture proposée dans l'article de Pandey et al, intitulé « A 120µW MICS/ISM-band FSK receiver with a 44µW low-power mode based on injection locking and 9x frequency multiplication », publié dans IEEE ISSCC Dig. Tech. Papers, pp. 460-462, février 2011, présente un résonateur à quartz externe dont le temps d'établissement est trop long pour des récepteurs activés sur des cycles courts.

Conscient de ces limitations, l'article de Salazar et al, intitulé « A -97dBm-sensitivity interferer-resilient 2.4GHz wake-up receiver using dual-IF multi-N-path architecture in 65nm CMOS », publié dans IEEE ISSCC Dig. Tech. Papers, pp. 242-244, février 2015, propose une architecture selon laquelle les signaux radiofréquence sont transposés une première fois autour d'une fréquence intermédiaire IF à l'aide d'un oscillateur local libre et d'un premier mélangeur filtrant, puis une deuxième fois, à partir de la fréquence intermédiaire IF, en bande de base à l'aide du même oscillateur local associé à un diviseur (de facteur N) et d'un deuxième mélangeur filtrant. Les signaux sont filtrés autour de la fréquence de l'oscillateur local pour le premier mélangeur et autour de la fréquence de l'oscillateur local divisée d'un facteur N pour le deuxième. L'opération ainsi réalisée vise à rejeter les fréquences non désirées et à améliorer la sensibilité et la sélectivité du dispositif récepteur.

Cependant, cette structure souffre d'un inconvénient majeur. Comme les filtres sont centrés sur des fréquences précises, il faut impérativement qu'à tout instant la fréquence de l'oscillateur local divisée d'un facteur N soit égale à la fréquence intermédiaire IF pour que le signal utile ne soit pas filtré. Or N est nécessairement un nombre entier. Donc la fréquence de l'oscillateur local doit être connue et parfaitement maitrisée quelles que soient les conditions. Or un oscillateur libre a une fréquence qui dépend du procédé technologique, de la température et de la tension d'alimentation. Tous ces paramètres pouvant varier et n'étant pas corrélés, il convient de calibrer régulièrement cet oscillateur local et de connaitre parfaitement sa fréquence pour faire fonctionner l'ensemble. Ces contraintes rendent difficile le démarrage et l'arrêt rapide d'un tel oscillateur au cours de cycles courts.

Le document US 2010/0197256 A1 porte sur un dispositif récepteur de signaux radiofréquence comportant un système de filtrage passe-bande, configuré et placé pour filtrer des signaux entrants selon une bande passante de largeur fréquentielle réglable. Il divulgue des moyens de réglage de la fréquence centrale et de la largeur de bande passante du système de filtrage passe-bande. Ce réglage se fait sur la base de critères tels qu'une localisation géographique, une information spectrale ou un statut de radio interne secondaire.

Il peut ainsi être souhaité de prévoir un dispositif récepteur de signaux radiofréquence qui permette de s'affranchir d'au moins une partie des problèmes et contraintes précités.

Il est donc proposé un dispositif récepteur de signaux radiofréquence tel que revendiqué dans la revendication 1.

Ainsi, sans avoir besoin d'un oscillateur local très précis et sans avoir besoin non plus de maîtriser ou connaître précisément sa fréquence d'oscillation, une solution simple à automatiser et rapide à mettre en œuvre est apportée, consistant à compenser cette imprécision par un réglage à l'aide d'un code d'identification prédéterminé à détecter. Une telle solution est notamment avantageusement mise en œuvre pour un dispositif récepteur destiné à s'activer de façon sporadique au cours de cycles prédéterminés courts, comme il en existe dans le domaine des récepteurs à ultra faible consommation.

De façon optionnelle, les caractéristiques revendiquées dans les revendications dépendantes 2 à 5 sont considérées dans des modes de réalisation de l'invention.

Il est également proposé un système récepteur de signaux radiofréquence, comportant un dispositif récepteur principal et un dispositif récepteur secondaire de signaux radiofréquence, dans lequel :
- le dispositif récepteur secondaire est programmé pour s'activer sporadiquement au cours de cycles prédéterminés et est un dispositif récepteur de signaux radiofréquence tel que revendiqué dans l'une quelconque des revendications 1 à 5,
- le dispositif récepteur principal est activable par le dispositif récepteur secondaire, et
- le dispositif récepteur secondaire est programmé pour activer le dispositif récepteur principal sur détection, par son détecteur, du code d'identification prédéterminé.

Il est également proposé un procédé de réglage d'un dispositif de réception de signaux radiofréquence tel que revendiqué dans la revendication 7.

Il est également proposé un programme d'ordinateur téléchargeable depuis un réseau de communication et/ou enregistré sur un support lisible par ordinateur et/ou exécutable par un processeur, comportant des instructions pour l'exécution d'un procédé de réglage tel que revendiqué dans la revendication 7, lorsque ledit programme est exécuté sur un processeur de dispositif de réception de signaux radiofréquence.

L'invention sera mieux comprise à l'aide de la description qui va suivre, donnée uniquement à titre d'exemple et faite en se référant aux dessins annexés dans lesquels :
- la figure 1 représente schématiquement la structure générale d'un système récepteur de signaux radiofréquence, selon un mode de réalisation de l'invention,
- les figures 2 et 3 illustrent deux politiques possibles de parcours de paramètres de réglage pour la mise en œuvre d'un procédé de réglage, selon l'invention, d'un dispositif récepteur secondaire du système de la figure 1, et
- les figures 4 à 7 illustrent les étapes successives de différents modes de réalisation d'un procédé de réglage selon l'invention.

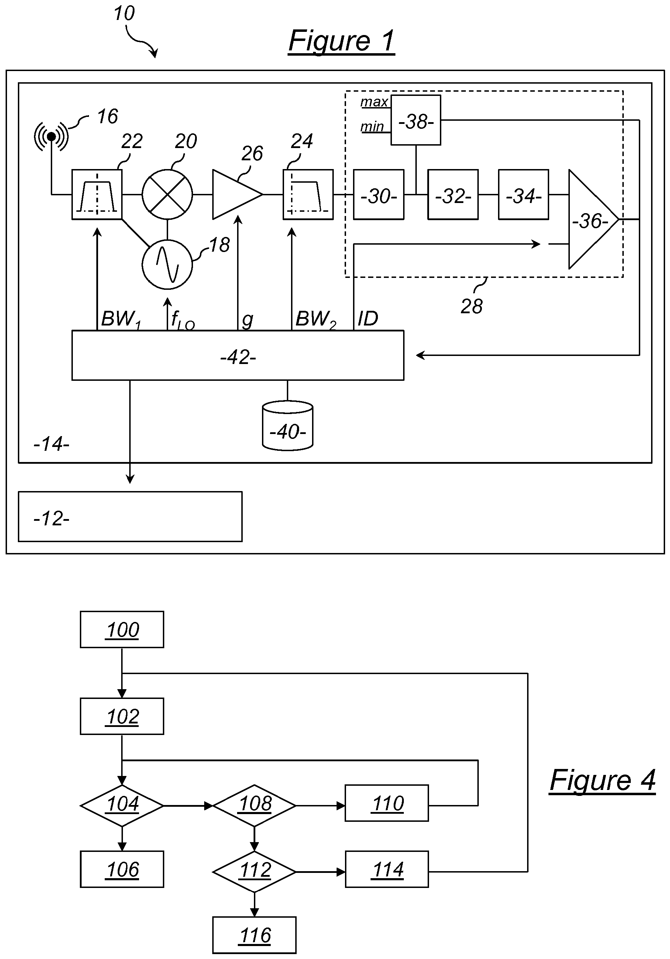

Le système récepteur 10 de signaux radiofréquence tel qu'illustré schématiquement sur la figure 1 comporte un dispositif récepteur principal 12 et un dispositif récepteur secondaire 14 de signaux radiofréquence modulés autour d'une fréquence porteuse *f_{RF}.* Il s'agit par exemple d'un système à ultra faible consommation, c'est-à-dire strictement inférieure à un milliwatt, dont le dispositif récepteur secondaire 14 est programmé pour s'activer sporadiquement au cours de cycles prédéterminés et pour activer le dispositif récepteur principal 12 lorsque c'est nécessaire, par exemple pour répondre à une demande de communication sans fil, lors de ces cycles.

Le dispositif récepteur principal 12 ne sera pas détaillé. Il est d'architecture bien connue et sa très faible consommation est assurée par le fait qu'il ne s'active que sur sollicitation du dispositif récepteur secondaire 14.

Le dispositif récepteur secondaire 14 comporte une antenne réceptrice 16 de signaux radiofréquence raccordée à une chaîne de traitement de signaux.

Cette chaîne de traitement comporte un oscillateur local 18 oscillant à une fréquence locale réglable *f_{LO}.*

La chaîne de traitement comporte en outre un mélangeur 20 recevant les signaux radiofréquence et la sortie de l'oscillateur local 18 pour la fourniture de signaux à fréquence intermédiaire *f_{IF}* = *f_{RF}* - *f_{LO}.*

Elle comporte en outre un système de filtrage, passe-bas ou passe-bande, configuré et placé pour filtrer les signaux à fréquence intermédiaire ou radiofréquence selon une bande passante de largeur fréquentielle réglable. Plus précisément, le système de filtrage peut comporter un filtre passe-bande 22 placé fonctionnellement en amont du mélangeur 20 dans le sens de traitement des signaux reçus pour filtrer les signaux radiofréquence. Concrètement, ce filtre passe-bande 22 peut être intégré au mélangeur 20. Concrètement également, sa fréquence centrale peut être fixée par construction ou plus avantageusement imposée à la valeur *f_{LO}* par commande de l'oscillateur local 18. Sa largeur fréquentielle de bande passante réglable est notée *BW*₁*.* Le système de filtrage peut également comporter un filtre passe-bas 24 placé fonctionnellement en aval du mélangeur 20 dans le sens de traitement des signaux reçus pour filtrer les signaux à fréquence intermédiaire. Sa largeur fréquentielle de bande passante réglable est notée *BW*₂*.* Le système de filtrage peut comporter l'un ou l'autre de ces deux filtres 22, 24, ou les deux. Il convient de noter que le filtre passe-bas 24 est fonctionnellement équivalent au filtre passe-bande 22 lorsque ce dernier est commandé par l'oscillateur local 18 pour être centré autour de la fréquence *f_{LO}.*

La chaîne de traitement comporte en outre de façon optionnelle un amplificateur 26 à gain *g* réglable. Cet amplificateur 26 est disposé, dans l'exemple non limitatif de la figure 1, entre le mélangeur 20 et le filtre passe-bas 24. Mais il pourrait aussi être disposé en amont du mélangeur 20, par exemple avant ou après le filtre passe-bande 22, ou même en aval du filtre passe-bas 24. Plus il est disposé en amont dans la chaîne de traitement, mieux il peut fonctionner en tant qu'amplificateur à faible bruit pour assurer un rapport signal sur bruit élevé, mais plus il est en aval, moins il est susceptible de consommer d'énergie.

La chaîne de traitement comporte enfin un module 28 de détection de données dans les signaux à fréquence intermédiaire fournis en sortie du mélangeur 20, après traitement éventuel par l'amplificateur 26 et le filtre passe-bas 24.

Ce détecteur 28 comporte par exemple tout d'abord un détecteur d'enveloppe 30 dont la fonction est de ramener analogiquement les signaux à fréquence intermédiaire en bande de base. La sortie de ce détecteur d'enveloppe 30 est fournie en entrée d'un convertisseur analogique-numérique 32 pour l'obtention d'un flux de données binaires puis à un décodeur 34 pour l'obtention d'informations numériques décodées. Les informations numériques décodées sont alors fournies à l'une des entrées d'un comparateur numérique 36 dont l'autre entrée est alimentée par un code d'identification prédéterminé ID. Ce code d'identification est par exemple un mot de 8 bits, un numéro de série du système récepteur 10, ou tout autre identifiant unique prédéterminé. Le comparateur 36 présente une sortie à « 0 » tant que les informations numériques ne comportent pas le code d'identification ID et à « 1 » dès que ce code d'identification ID y est détecté. Enfin, le détecteur 28 peut comporter un comparateur supplémentaire 38 dont la fonction est de déterminer si les signaux reçus convertis en données binaires ne comportent que des bits à « 0 », ce qui signifie une absence de signal significatif, ou que des bits à « 1 », ce qui signifie une saturation du dispositif récepteur secondaire 14. Ce comparateur supplémentaire 38 peut être analogique et disposé en sortie du détecteur d'enveloppe 30, parallèlement au convertisseur analogique-numérique 32, au décodeur 34 et au comparateur 36 : dans ce cas, illustré sur la figure 1, l'absence de signal significatif et la saturation sont détectées avant conversion numérique à l'aide de valeurs seuil « *min* » et « max » comparées à l'enveloppe de signal analogique fournie par le détecteur 30. De façon alternative, le comparateur supplémentaire 38 pourrait être numérique et disposé en sortie du convertisseur analogique-numérique 32, parallèlement au décodeur 34 et au comparateur 36 : dans ce cas, non illustré, l'absence de signal significatif et la saturation sont détectées après conversion numérique dans le flux de données binaires fourni par le convertisseur analogique-numérique 32. En variante, ce comparateur supplémentaire 38 pourrait même être remplacé par un détecteur de puissance disposé en amont du détecteur 28.

Le dispositif récepteur secondaire 14 comporte une mémoire 40 pour le stockage du code d'identification ID et de paramètres relatifs à la fréquence d'oscillation locale *f_{LO},* à la largeur fréquentielle de bande passante *BW*₁ et/ou *BW*₂ notée de façon générique *BW* par souci de simplicité dans la suite de la description, et au gain *g*. Plus précisément, les paramètres stockés en mémoire 40 peuvent comporter : un paramètre *f_{LO}*[*min*] de fréquence d'oscillation minimale de l'oscillateur local 18, un paramètre *f_{LO}*[*max*] de fréquence d'oscillation maximale de l'oscillateur local 18, un paramètre *BW*[*min*] de largeur fréquentielle minimale de bande passante pour le filtre 22 ou 24, un paramètre *BW*[*max*] de largeur fréquentielle maximale de bande passante pour le filtre 22 ou 24, un paramètre *g*[*min*] de gain minimal de l'amplificateur 26 et un paramètre *g*[*max*] de gain maximal de l'amplificateur 26.

De façon optionnelle, les paramètres stockés en mémoire pourraient aussi comporter des valeurs de fréquences de coupure pour le système de filtrage.

De façon avantageuse, le paramètre BW[min] de largeur fréquentielle minimale de bande passante est défini de sorte que cette largeur fréquentielle minimale soit inférieure à la différence entre les fréquences d'oscillation minimale et maximale relatives aux paramètres correspondants f_{LO}[min] et f_{LO}[max], i.e. BW[min] < (f_{LO}[max] - f_{LO}[min]). En d'autres termes, dans les choix de largeurs fréquentielles de bandes passantes pour le système de filtrage, au moins l'une d'entre elles est avantageusement inférieure à la plage fréquentielle observée. Cela permet de rendre le filtrage réellement sélectif.

Le dispositif récepteur secondaire 14 comporte en outre un processeur 42 de traitement des données fournies en sortie du détecteur 28, notamment les sorties des comparateurs 36 et 38, et de prise en compte des paramètres mentionnés précédemment, pour le réglage de la fréquence locale *f_{LO}* de l'oscillateur local 18, entre les fréquences d'oscillation minimale et maximale relatives aux paramètres correspondants *f_{LO}*[*min*] et *f_{LO}*[*max*]*,* pour le réglage de la largeur fréquentielle de bande passante *BW* du système de filtrage 22, 24, entre les largeurs fréquentielles minimale et maximale relatives aux paramètres correspondants *BW[min]* et *BW[max],* et éventuellement pour le réglage du gain *g* de l'amplificateur 26, entre les gains minimal et maximal relatifs aux paramètres correspondants *g*[*min*] et *g*[*max*]*,* jusqu'à détecter, à l'aide du comparateur 36 du détecteur 28, le code d'identification ID dans l'un des signaux à fréquence intermédiaire fournis en entrée de ce détecteur 28.

Concrètement, et pour simplifier ce réglage, le processeur 42 peut parcourir des tables de paramètres définis entre les valeurs extrêmes précitées pour procéder à la recherche du code d'identification ID, ces tables de paramètres étant prédéfinies et stockées en mémoire 40. Le parcours de ces tables peut être exécuté selon différentes politiques préétablies.

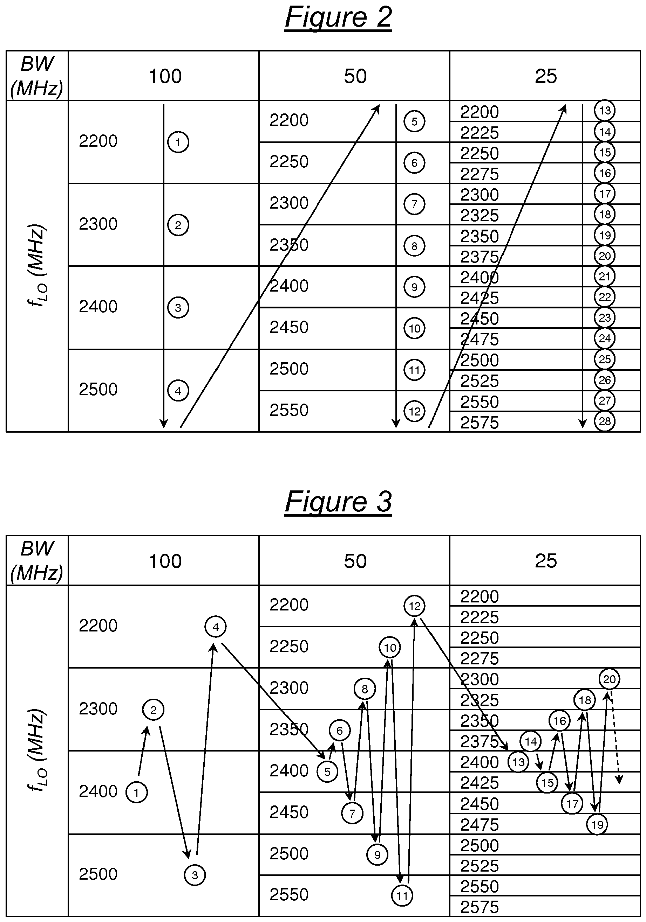

Un exemple de table de paramètres avec une première politique de parcours est illustré sur la figure 2. Dans cet exemple simplifié, seuls les paramètres relatifs à la fréquence d'oscillation locale *f_{LO}* et à la largeur fréquentielle de bande passante générique *BW* sont indiqués par souci de simplicité, l'amplificateur 26 et son gain *g* n'étant pas pris en compte. Plus précisément, *f_{LO}*[*min*] = 2200 MHz, *f_{LO}*[*max*] = 2575 MHz, *BW*[*min*] = 25 MHz et *BW*[*max*] = 100 MHz. Entre *f_{LO}*[*min*] et *f_{LO}*[*max*]*,* la table prévoit que la fréquence d'oscillation locale *f_{LO}* puisse aussi prendre les valeurs 2225 MHz, 2250 MHz, 2275 MHz, 2300 MHz, 2325 MHz, 2350 MHz, 2375 MHz, 2400 MHz, 2425 MHz, 2450 MHz, 2475 MHz, 2500 MHz, 2525 MHz et 2550 MHz. Entre *BW*[*min*] et *BW*[*max*]*,* la table prévoit en outre que la largeur fréquentielle de bande passante *BW* puisse aussi prendre la valeur 50 MHz. Etant donné que les sauts d'une fréquence d'oscillation locale à une autre doivent être cohérents avec la largeur fréquentielle de bande passante sélectionnée, toutes les valeurs 2200 MHz, 2225 MHz, 2250 MHz, 2275 MHz, 2300 MHz, 2325 MHz, 2350 MHz, 2375 MHz, 2400 MHz, 2425 MHz, 2450 MHz, 2475 MHz, 2500 MHz, 2525 MHz, 2550 MHz et 2575 MHz de fréquence d'oscillation locale *f_{LO}* peuvent être explorées pour *BW* = *BW*[*min*] = 25 MHz ; seules les valeurs 2200 MHz, 2250 MHz, 2300 MHz, 2350 MHz, 2400 MHz, 2450 MHz, 2500 MHz et 2550 MHz de fréquence d'oscillation locale *f_{LO}* sont explorées pour *BW* = 50 MHz ; et seules les valeurs 2200 MHz, 2300 MHz, 2400 MHz et 2500 MHz de fréquence d'oscillation locale *f_{LO}* sont explorées pour *BW* = *BW*[*max*] = 100 MHz.

Selon cet exemple de politique de parcours de la table de paramètres, les couples de valeurs pour (*BW*,*f_{LO}*) sont explorés en MHz dans l'ordre suivant : (100, 2200), puis (100, 2300), puis (100, 2400), puis (100, 2500), puis (50, 2200), puis (50, 2250), puis (50, 2300), puis (50, 2350), puis (50, 2400), puis (50, 2450), puis (50, 2500), puis (50, 2550), puis (25, 2200), puis (25, 2225), puis (25, 2250), puis (25, 2275), puis (25, 2300), puis (25, 2325), puis (25, 2350), puis (25, 2375), puis (25, 2400), puis (25, 2425), puis (25, 2450), puis (25, 2475), puis (25, 2500), puis (25, 2525), puis (25, 2550), puis (25, 2575).

Un autre exemple de politique de parcours de la même table de paramètres est illustré sur la figure 3. Selon cet autre exemple, les couples de valeurs pour (*BW*,*f_{LO}*) sont explorés en MHz dans l'ordre plus complexe mais plus astucieux suivant : (100, 2400), puis (100, 2300), puis (100, 2500), puis (100, 2200), puis (50, 2400), puis (50, 2350), puis (50, 2450), puis (50, 2300), puis (50, 2500), puis (50, 2250), puis (50, 2550), puis (50, 2200), puis (25, 2400), puis (25, 2375), puis (25, 2425), puis (25, 2350), puis (25, 2450), puis (25, 2325), puis (25, 2475), puis (25, 2300), puis (25, 2500), puis (25, 2275), puis (25, 2525), puis (25, 2250), puis (25, 2550), puis (25, 2525), puis (25, 2575), puis (25, 2200).

Une grande variété d'autres politiques de parcours d'une même table peut être envisagée.

Un premier exemple de fonctionnement du dispositif récepteur secondaire 14, et plus précisément de son processeur 42, va maintenant être détaillé en référence au procédé de réglage dont les étapes sont illustrées sur la figure 4. Ce procédé de réglage est mis en oeuvre par un ou plusieurs programmes d'ordinateurs dont les instructions sont stockées en mémoire 40 et destinées à être exécutées par le processeur 42. Mais leurs fonctions pourraient aussi être au moins en partie micro programmées ou micro câblées dans des circuits intégrés dédiés. Ainsi, en variante, le dispositif informatique mettant en oeuvre le processeur 42 et la mémoire 40 pourrait être remplacé par un dispositif électronique composé uniquement de circuits numériques (sans programme d'ordinateur) pour la réalisation des mêmes actions.

Ce procédé est conforme à la table de paramètres et aux politiques de parcours illustrées par les figures 2 et 3. Il pourrait être aisément adapté à d'autres tables de paramètres et/ou d'autres politiques de parcours. Dans le cas du dispositif récepteur secondaire 14, il s'exécute au cours des cycles prédéterminés d'activation sporadique.

Au cours d'une première étape d'initialisation 100, la largeur fréquentielle de bande passante *BW* est initialisée à sa première valeur dans la politique de parcours préétablie, par exemple *BW* = *BW*[*max*] conformément aux figures 2 et 3.

Au cours d'une deuxième étape d'initialisation 102, la fréquence d'oscillation locale *f_{LO}* est initialisée à sa première valeur dans la politique de parcours préétablie, par exemple *f_{LO}* = *f_{LO}*[*min*] conformément à la figure 2 ou *f_{LO}* = 2400 MHz conformément à la figure 3.

Au cours d'une étape de test suivante 104, les signaux reçus par le dispositif récepteur sont traités par la chaîne de traitement et la sortie du comparateur 36 est surveillée pendant une durée correspondant à une fréquence attendue de réception du code d'identification ID.

Si le code d'identification ID est détecté, le procédé de réglage passe à une étape 106 de fin de réglage au cours de laquelle le dispositif récepteur secondaire 14 active le dispositif récepteur principal 12 sur la base du couple de valeurs (*BW*,*f_{LO}*) en cours.

Sinon, le procédé de réglage passe à une nouvelle étape de test 108 au cours de laquelle on vérifie si la valeur de fréquence d'oscillation locale *f_{LO}* courante est la dernière à explorer pour la valeur de largeur fréquentielle de bande passante *BW* courante.

S'il reste encore au moins une valeur de fréquence d'oscillation locale *f_{LO}* à explorer pour la valeur de largeur fréquentielle de bande passante *BW* courante, le procédé de réglage passe à une étape 110 d'incrémentation de la fréquence d'oscillation locale *f_{LO}* à la valeur suivante dans la politique de parcours préétablie. Cette étape 110 est suivie d'un retour à l'étape de test 104.

Sinon, le procédé de réglage passe à une nouvelle étape de test 112 au cours de laquelle on vérifie si la valeur de largeur fréquentielle de bande passante *BW* courante est la dernière à explorer.

S'il reste encore au moins une valeur de largeur fréquentielle de bande passante *BW* à explorer, le procédé de réglage passe à une étape 114 d'incrémentation de la largeur fréquentielle de bande passante *BW* à la valeur suivante dans la politique de parcours préétablie. Cette étape 114 est suivie d'un retour à la deuxième étape d'initialisation 102.

Sinon, le procédé passe à une dernière étape 116 de fin de réglage, le code d'identification ID n'ayant pas été détecté. Dans ce cas, le dispositif récepteur secondaire 14 peut se remettre en état de veille et attendre un nouveau cycle d'activation.

On remarquera que cet exemple de procédé de réglage particulièrement simple ne sollicite pas le comparateur supplémentaire 38. On notera également qu'il est aisé de l'adapter pour un réglage du gain *g* de l'amplificateur 26 en plus de celui des paramètres *BW* et *f_{LO}.*

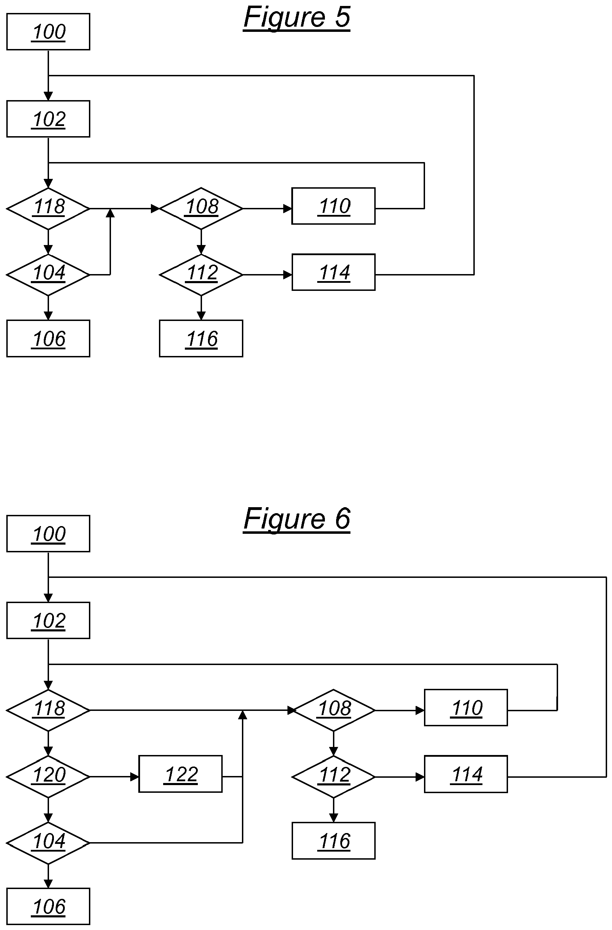

Un deuxième exemple de fonctionnement du dispositif récepteur secondaire 14, et plus précisément de son processeur 42, va maintenant être détaillé en référence au procédé de réglage dont les étapes sont illustrées sur la figure 5. Comme le précédent, ce procédé de réglage peut être mis en oeuvre par programme d'ordinateur ou être en partie micro programmé ou micro câblé dans des circuits intégrés dédiés. Ce procédé est lui aussi conforme à la table de paramètres et aux politiques de parcours illustrées par les figures 2 et 3, mais il pourrait être aisément adapté à d'autres tables de paramètres et/ou d'autres politiques de parcours.

Ce deuxième exemple est quasiment identique au précédent. Il ne s'en distingue que par l'insertion d'une étape de test 118 entre les étapes 102 et 104. Au cours de cette étape 118, un test sur la puissance détectée est exécuté. Si cette puissance est inférieure à une valeur seuil prédéterminée, alors le procédé de réglage passe directement à l'étape 108 sans effectuer le test de l'étape 104. Sinon il passe à l'étape 104. Le test de l'étape 118 peut être réalisé à l'aide du comparateur supplémentaire 38 en réglant son entrée « *min* » à la valeur seuil souhaitée. C'est alors l'absence de signal significatif (i.e. les signaux reçus convertis en données binaires ne comportent que des bits à « 0 ») conclue en sortie de ce comparateur supplémentaire 38 qui permet de passer directement à l'étape 108. Il peut aussi être réalisé en insérant un détecteur de puissance en amont du détecteur 28, pouvant par exemple intégrer l'énergie contenue dans le spectre des signaux à fréquence intermédiaire IF pendant un certain temps.

Un troisième exemple de fonctionnement du dispositif récepteur secondaire 14, et plus précisément de son processeur 42, va maintenant être détaillé en référence au procédé de réglage dont les étapes sont illustrées sur la figure 6. Comme le précédent, ce procédé de réglage peut être mis en oeuvre par programme d'ordinateur ou être en partie micro programmé ou micro câblé dans des circuits intégrés dédiés. Ce procédé est lui aussi conforme à la table de paramètres et aux politiques de parcours illustrées par les figures 2 et 3, mais il pourrait être aisément adapté à d'autres tables de paramètres et/ou d'autres politiques de parcours.

Ce troisième exemple est quasiment identique au précédent. Il ne s'en distingue que par l'insertion de deux étapes 120 et 122 entre les étapes 118 et 104.

Au cours de l'étape 120, un autre test sur la puissance détectée est exécuté. Si cette puissance est supérieure à une autre valeur seuil prédéterminée, alors le procédé de réglage passe à l'étape 122 de marquage d'un bit de signalisation à « 1 » puis directement à l'étape 108 sans effectuer le test de l'étape 104. Le test de l'étape 120 peut être réalisé à l'aide du comparateur supplémentaire 38 en réglant son entrée « *max* » à la valeur seuil souhaitée. C'est alors la saturation (i.e. les signaux reçus convertis en données binaires ne comportent que des bits à « 1 ») conclue en sortie de ce comparateur supplémentaire 38 qui permet de passer directement à l'étape 108 via l'étape 122. Cette saturation est signalée par le bit de signalisation à « 1 » qui peut ensuite être exploité de différentes manières, notamment lors d'un cycle ultérieur d'activation du dispositif récepteur secondaire 14.

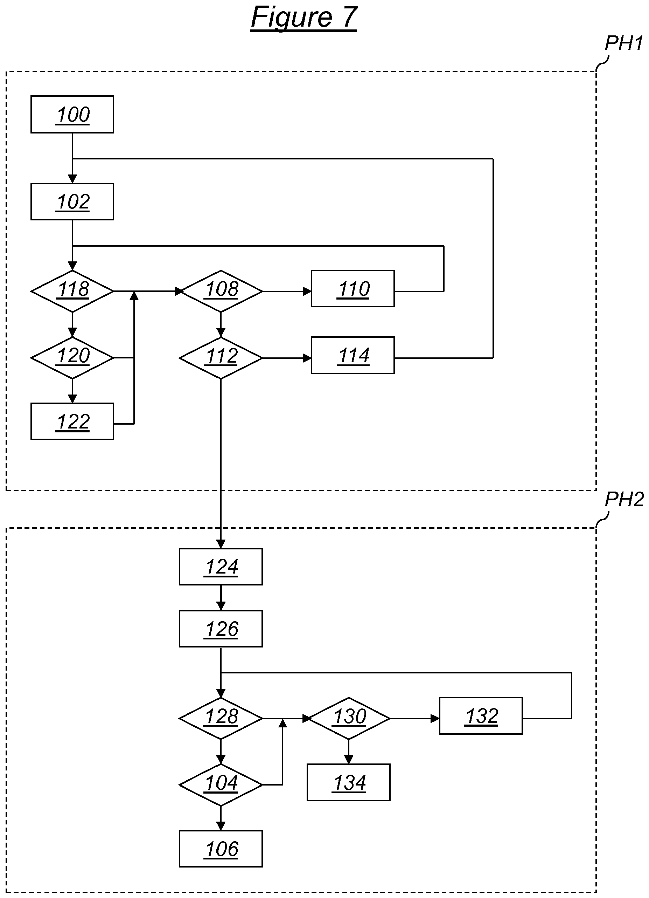

Un quatrième exemple de fonctionnement du dispositif récepteur secondaire 14, et plus précisément de son processeur 42, va maintenant être détaillé en référence au procédé de réglage dont les étapes sont illustrées sur la figure 7. Comme le précédent, ce procédé de réglage peut être mis en oeuvre par programme d'ordinateur ou être en partie micro programmé ou micro câblé dans des circuits intégrés dédiés. Ce procédé est lui aussi conforme à la table de paramètres et aux politiques de parcours illustrées par les figures 2 et 3, mais il pourrait être aisément adapté à d'autres tables de paramètres et/ou d'autres politiques de parcours.

Ce quatrième exemple se distingue du précédent en ce qu'il est séparé en deux phases, une première phase PH1 au cours de laquelle la table de paramètres prédéfinie est entièrement parcourue selon la politique préétablie uniquement pour effectuer une détection de puissance exploitant la sortie du comparateur supplémentaire 38, et une deuxième phase PH2 au cours de laquelle seules les valeurs (*BW*,*f_{LO}*) pour lesquelles l'absence de signal significatif et la saturation n'ont pas été conclues sont explorées pour identifier le code d'identification ID.

La première phase PH1 comporte les étapes 100, 102, 108, 110, 112, 114, 118, 120 et 122 décrites précédemment mais organisées de façon légèrement différente.

Au cours de la première étape d'initialisation 100, la largeur fréquentielle de bande passante *BW* est initialisée à sa première valeur dans la politique de parcours préétablie, par exemple *BW* = *BW*[*max*] conformément aux figures 2 et 3.

Au cours de la deuxième étape d'initialisation 102, la fréquence d'oscillation locale *f_{LO}* est initialisée à sa première valeur dans la politique de parcours préétablie, par exemple *f_{LO}* = *f_{LO}*[*min*] conformément à la figure 2 ou *f_{LO}* = 2400 MHz conformément à la figure 3.

Au cours de l'étape de test suivante 118, si la sortie du comparateur supplémentaire 38 indique une absence de signal significatif alors le procédé de réglage passe à l'étape 108, sinon il passe à l'étape 120.

Au cours de l'étape de test 120, si la sortie du comparateur supplémentaire 38 indique une saturation alors le procédé de réglage passe à l'étape 108, sinon il passe à l'étape 122 avant de passer à l'étape 120. Ainsi, le bit de signalisation est à « 1 » en présence d'un signal significatif non saturant pour les valeurs du couple (*BW*,*f_{LO}*) en cours.

Au cours de l'étape de test 108, on vérifie si la valeur de fréquence d'oscillation locale *f_{LO}* courante est la dernière à explorer pour la valeur de largeur fréquentielle de bande passante *BW* courante.

S'il reste encore au moins une valeur de fréquence d'oscillation locale *f_{LO}* à explorer pour la valeur de largeur fréquentielle de bande passante *BW* courante, le procédé de réglage passe à l'étape 110 d'incrémentation de la fréquence d'oscillation locale *f_{LO}* à la valeur suivante dans la politique de parcours préétablie. Cette étape 110 est suivie d'un retour à l'étape de test 118.

Sinon, le procédé de réglage passe à l'étape de test 112 au cours de laquelle on vérifie si la valeur de largeur fréquentielle de bande passante *BW* courante est la dernière à explorer.

S'il reste encore au moins une valeur de largeur fréquentielle de bande passante *BW* à explorer, le procédé de réglage passe à l'étape 114 d'incrémentation de la largeur fréquentielle de bande passante *BW* à la valeur suivante dans la politique de parcours préétablie. Cette étape 114 est suivie d'un retour à la deuxième étape d'initialisation 102.

Sinon, le procédé passe à la deuxième phase PH2.

Au cours de cette deuxième phase, la table de paramètre peut être de nouveau parcourue selon l'enchaînement des étapes 100, 102, 108, 110, 112 et 114 en ne sollicitant le comparateur 36 par exécution de l'étape de test 104 que lorsque le bit de signalisation est à « 1 » pour un couple (*BW*,*f_{LO}*) donné. En variante, si l'on part du principe qu'au moins l'un des couples (*BW*[*min*]*, f_{LO}*) est associé à un bit de signalisation à « 1 », alors la deuxième phase PH2 peut être accélérée.

Comme illustré sur la figure 7, la deuxième phase PH2 comporte alors une première étape 124 au cours de laquelle la largeur fréquentielle de bande passante *BW* est portée à *BW*[*min*]*.* Cette première étape 124 est suivie d'une étape 126 identique à l'étape 102.

L'étape 126 est suivie d'une étape de test 128 portant sur le bit de signalisation. Si celui-ci est à « 0 » alors le procédé de réglage passe à une étape de test 130 identique à l'étape 108.

Lors de l'étape 130, s'il reste encore au moins une valeur de fréquence d'oscillation locale *f_{LO}* à explorer, le procédé de réglage passe à une étape 132 d'incrémentation de la fréquence d'oscillation locale *f_{LO}* à la valeur suivante dans la politique de parcours préétablie. Cette étape 132 est suivie d'un retour à l'étape de test 128. S'il ne reste pas de valeur de fréquence d'oscillation locale *f_{LO}* à explorer, le procédé passe à une dernière étape 134 de fin de réglage identique à l'étape 116.

Lors de l'étape de test 128, si le bit de signalisation est à « 1 », le procédé de réglage passe à l'étape de test 104, suivie de l'étape 106 si le test est positif (code d'identification ID détecté) ou de l'étape 130 sinon.

Il apparaît clairement qu'un système récepteur tel que celui décrit précédemment permet d'envisager des rapports cycliques d'activations sporadiques très courts, une très faible consommation et une bonne sensibilité. Le coût est également réduit parce que l'on s'affranchit de la nécessité de prévoir un oscillateur local précis ou maîtrisé.

Cette solution innovante permet de fonctionner sur une plage de fréquences étendue ne dépendant que de la plage d'accord de l'oscillateur local.

On accède en outre à des bandes passantes de filtrage qui ne sont envisageables autrement qu'en technologie de circuit intégré et le système de filtrage est accordable sur toute la plage d'accord de l'oscillateur local puisqu'il peut être centré sur sa fréquence d'oscillation.

On notera par ailleurs que l'invention n'est pas limitée aux modes de réalisation décrits précédemment.

Ainsi en variante, les paramètres stockés en mémoire pourraient aussi comporter des valeurs d'orientation du diagramme de réception de l'antenne 16 du dispositif récepteur secondaire 14 pour un réglage spatial. Il est notamment possible d'utiliser pour cela une méthode similaire à celle proposée dans l'article de Ghaffari et al, intitulé « A 4-element phased-array system with simultaneous spatial- and frequency-domain filtering at the antenna inputs », publié dans IEEE Journal of Solid-state Circuits, vol. 49, n° 6, pp. 1303-1316, juin 2014.

Il apparaîtra plus généralement à l'homme de l'art que diverses modifications peuvent être apportées aux modes de réalisation décrits ci-dessus, à la lumière de l'enseignement qui vient de lui être divulgué. Dans les revendications qui suivent, les termes utilisés ne doivent pas être interprétés comme limitant les revendications aux modes de réalisation exposés dans la présente description, mais doivent être interprétés pour y inclure tous les équivalents que les revendications visent à couvrir du fait de leur formulation et dont la prévision est à la portée de l'homme de l'art en appliquant ses connaissances générales à la mise en oeuvre de l'enseignement qui vient de lui être divulgué.

## Revendications

1. Dispositif (14) récepteur de signaux radiofréquence comportant :
- un oscillateur local (18) oscillant à une fréquence locale réglable,
- un mélangeur (20) recevant les signaux radiofréquence et la sortie de l'oscillateur local (18) pour la fourniture de signaux à fréquence intermédiaire,
- au moins l'un des éléments de l'ensemble constitué :
• d'un système de filtrage passe-bande (22), configuré et placé fonctionnellement en amont du mélangeur (20) dans le sens de traitement des signaux reçus pour filtrer les signaux radiofréquence selon une bande passante de largeur fréquentielle réglable, et
• d'un système de filtrage passe-bas (24), configuré et placé fonctionnellement en aval du mélangeur (20) dans le sens de traitement des signaux reçus pour filtrer les signaux à fréquence intermédiaire selon une bande passante de largeur fréquentielle réglable, et
- un détecteur (28) configuré pour détecter des données dans les signaux à fréquence intermédiaire,
**caractérisé en ce qu'**il comporte en outre :
- des moyens (40) de stockage d'un code d'identification prédéterminé, d'un paramètre de fréquence d'oscillation minimale d'oscillateur local, d'un paramètre de fréquence d'oscillation maximale d'oscillateur local, d'un paramètre de largeur fréquentielle minimale de bande passante et d'un paramètre de largeur fréquentielle maximale de bande passante, et
- des moyens (42) de réglage de la fréquence locale de l'oscillateur local (18), entre les fréquences d'oscillation minimale et maximale, et de réglage de la bande passante du système de filtrage (22, 24), entre les largeurs fréquentielles minimale et maximale, adaptés pour régler cette fréquence locale et cette bande passante jusqu'à ce que le détecteur (28) détecte le code d'identification prédéterminé dans l'un des signaux à fréquence intermédiaire.

2. Dispositif (14) récepteur de signaux radiofréquence selon la revendication 1, comportant au moins le système de filtrage passe-bande (22) et dans lequel le système de filtrage passe-bande (22) est commandé par l'oscillateur local (18) de manière à être centré autour de la fréquence locale réglable.

3. Dispositif (14) récepteur de signaux radiofréquence selon la revendication 1 ou 2, dans lequel le paramètre de largeur fréquentielle minimale de bande passante est défini de sorte que cette largeur fréquentielle minimale soit inférieure à la différence entre les fréquences d'oscillation minimale et maximale.

4. Dispositif (14) récepteur de signaux radiofréquence selon l'une quelconque des revendications 1 à 3, comportant un amplificateur (26) à gain réglable, dans lequel :
- les moyens de stockage (40) stockent un paramètre de gain minimal et un paramètre de gain maximal, et
- les moyens de réglage (42) sont en outre conçus pour régler le gain de l'amplificateur (26), entre les gains minimal et maximal, et adaptés pour régler ce gain jusqu'à ce que le détecteur (28) détecte le code d'identification prédéterminé dans l'un des signaux à fréquence intermédiaire.

5. Dispositif (14) récepteur de signaux radiofréquence selon l'une quelconque des revendications 1 à 4, dans lequel les moyens de stockage (40) sont configurés pour stocker au moins une table de paramètres prédéfinis entre au moins le paramètre de fréquence d'oscillation minimale d'oscillateur local, le paramètre de fréquence d'oscillation maximale d'oscillateur local, le paramètre de largeur fréquentielle minimale de bande passante et le paramètre de largeur fréquentielle maximale de bande passante, ainsi qu'au moins une politique préétablie de parcours de cette table de paramètres.

6. Système récepteur de signaux radiofréquence, comportant un dispositif récepteur principal (12) et un dispositif récepteur secondaire (14) de signaux radiofréquence, dans lequel :
- le dispositif récepteur secondaire (14) est programmé pour s'activer sporadiquement au cours de cycles prédéterminés et est un dispositif récepteur de signaux radiofréquence selon l'une quelconque des revendications 1 à 5,
- le dispositif récepteur principal (12) est activable par le dispositif récepteur secondaire (14), et
- le dispositif récepteur secondaire (14) est programmé pour activer le dispositif récepteur principal (12) sur détection, par son détecteur (28), du code d'identification prédéterminé.

7. Procédé de réglage d'un dispositif de réception de signaux radiofréquence, pour un dispositif (14) comportant :
- un oscillateur local (18) oscillant à une fréquence locale réglable,
- un mélangeur (20) recevant les signaux radiofréquence et la sortie de l'oscillateur local (18) pour la fourniture de signaux à fréquence intermédiaire,
- au moins l'un des éléments de l'ensemble constitué :
• d'un système de filtrage passe-bande (22), configuré et placé fonctionnellement en amont du mélangeur (20) dans le sens de traitement des signaux reçus pour filtrer les signaux radiofréquence selon une bande passante de largeur fréquentielle réglable, et
• d'un système de filtrage passe-bas (24), configuré et placé fonctionnellement en aval du mélangeur (20) dans le sens de traitement des signaux reçus pour filtrer les signaux à fréquence intermédiaire selon une bande passante de largeur fréquentielle réglable, et
- un détecteur (28) configuré pour détecter des données dans les signaux à fréquence intermédiaire, et
- des moyens (40) de stockage le procédé étant **caractérisé en ce que**, les moyens de stockage stockent un code d'identification prédéterminé, un paramètre de fréquence d'oscillation minimale d'oscillateur local, un paramètre de fréquence d'oscillation maximale d'oscillateur local, un paramètre de largeur fréquentielle minimale de bande passante et un paramètre de largeur fréquentielle maximale de bande passante, et **en ce qu'**il comporte un procédé de réglage (102, 110 ; 102, 110, 126, 132) de la fréquence locale de l'oscillateur local (18), entre les fréquences d'oscillation minimale et maximale et un réglage (100, 114) de la bande passante du système de filtrage (22, 24), entre les largeurs fréquentielles minimale et maximale, jusqu'à ce que le détecteur (28) détecte (104, 106) le code d'identification prédéterminé dans l'un des signaux à fréquence intermédiaire.

8. Programme d'ordinateur téléchargeable depuis un réseau de communication et/ou enregistré sur un support (40) lisible par ordinateur et/ou exécutable par un processeur, **caractérisé en ce qu'**il comprend des instructions pour l'exécution d'un procédé de réglage selon la revendication 7, lorsque ledit programme est exécuté sur un processeur (42) de dispositif (14) de réception de signaux radiofréquence.

## Patentansprüche

1. Empfangsvorrichtung (14) von Funkfrequenzsignalen, Folgendes beinhaltend:
- einen lokalen Oszillator (18), der auf einer einstellbaren lokalen Frequenz oszilliert,
- einen Mischer (20), der die Funkfrequenzsignale und den Ausgang des lokalen Oszillators (18) zum Bereitstellen von Zwischenfrequenzsignalen empfängt,
- wobei mindestens eines der Elemente der Baugruppe gebildet wird:
• aus einem Bandpassfiltersystem (22), das konfiguriert, und betrieblich stromaufwärts des Mischers (20) in der Verarbeitungsrichtung der empfangenen Signale platziert ist, um die Funkfrequenzsignale entsprechend einer Bandbreite einer einstellbaren Frequenzbreite zu filtern, und
• aus einem Tiefpassfiltersystem (24), das konfiguriert, und betrieblich stromabwärts des Mischers (20) in der Verarbeitungsrichtung der empfangenen Signale platziert ist, um die Zwischenfrequenzsignale entsprechend einer Bandbreite einer einstellbaren Frequenzbreite zu filtern, und
- einen Detektor (28), der konfiguriert ist, um Daten in den Zwischenfrequenzsignalen zu detektieren,
**dadurch gekennzeichnet, dass** sie weiter Folgendes beinhaltet:
- Mittel (40) zum Speichern eines vorbestimmten Identifikationscodes, eines Parameters einer Mindest-Oszillationsfrequenz eines lokalen Oszillators, eines Parameters einer maximalen Oszillationsfrequenz eines lokalen Oszillators, eines Parameters einer MindestFrequenzbreite einer Bandbreite und eines Parameters einer maximalen Frequenzbreite einer Bandbreite, und
- Mittel (42) zum Einstellen der lokalen Frequenz des lokalen Oszillators (18) zwischen den minimalen und maximalen Oszillationsfrequenzen, und zum Einstellen der Bandbreite des Filtersystems (22, 24) zwischen den minimalen und maximalen Frequenzbreiten, die angepasst sind, um diese lokale Frequenz und diese Bandbreite einzustellen, bis der Detektor (28) den vorbestimmten Identifikationscode in einem der Zwischenfrequenzsignale detektiert.

2. Empfangsvorrichtung (14) von Funkfrequenzsignalen nach Anspruch 1, mindestens das Bandpassfiltersystem (22) beinhaltend, und wobei das Bandpassfiltersystem (22) durch den lokalen Oszillator (18) gesteuert wird, um die einstellbare lokale Frequenz herum zentriert zu sein.

3. Empfangsvorrichtung (14) von Funkfrequenzsignalen nach Anspruch 1 oder 2, wobei der Parameter einer Mindestfrequenzbreite einer Bandbreite derart definiert wird, dass diese Mindestfrequenzbreite kleiner als die Differenz zwischen den minimalen und maximalen Oszillationsfrequenzen ist.

4. Empfangsvorrichtung (14) von Funkfrequenzsignalen nach einem der Ansprüche 1 bis 3, einen Verstärker (26) mit einstellbarem Amplitudenverhältnis beinhaltend, wobei:
- die Mittel (40) zum Speichern einen Parameter eines Mindestamplitudenverhältnisses und einen Parameter eines maximalen Amplitudenverhältnisses speichern, und
- die Mittel (42) zum Einstellen weiter gestaltet sind, um das Amplitudenverhältnis des Verstärkers (26) zwischen den minimalen und maximalen Amplitudenverhältnissen einzustellen, und angepasst sind, um dieses Amplitudenverhältnis einzustellen, bis der Detektor (28) den vorbestimmten Identifikationscode in einem der Zwischenfrequenzsignale detektiert.

5. Empfangsvorrichtung (14) von Funkfrequenzsignalen nach einem der Ansprüche 1 bis 4, wobei die Mittel (40) zum Speichern konfiguriert sind, um mindestens eine Tabelle mit Parametern zu speichern, die zwischen mindestens dem Parameter einer Mindest-Oszillationsfrequenz eines lokalen Oszillators, dem Parameter einer maximalen Oszillationsfrequenz eines lokalen Oszillators, dem Parameter einer MindestFrequenzbreite einer Bandbreite und dem Parameter einer maximalen Frequenzbreite einer Bandbreite, sowie mindestens einer zuvor erstellten Verlaufspolitik dieser Parametertabelle definiert sind.

6. Empfangssystem von Funkfrequenzsignalen, eine Hauptempfangsvorrichtung (12) und eine Sekundärempfangsvorrichtung (14) von Funkfrequenzsignalen beinhaltend, wobei:
- die Sekundärempfangsvorrichtung (14) programmiert ist, um sporadisch im Laufe von vorbestimmten Zyklen aktiviert zu werden, und eine Empfangsvorrichtung von Funkfrequenzsignalen nach einem der Ansprüche 1 bis 5 ist,
- die Hauptempfangsvorrichtung (12) durch die Sekundärempfangsvorrichtung (14) aktivierbar ist, und
- die Sekundärempfangsvorrichtung (14) programmiert ist, um die Hauptempfangsvorrichtung (12) bei Detektion, durch ihren Detektor (28), des vorbestimmten Identifikationscodes zu aktivieren.

7. Verfahren zum Einstellen einer Empfangsvorrichtung von Funkfrequenzsignalen, für eine Vorrichtung (14), Folgendes beinhaltend:
- einen lokalen Oszillator (18), der auf einer einstellbaren lokalen Frequenz oszilliert,
- einen Mischer (20), der die Funkfrequenzsignale und den Ausgang des lokalen Oszillators (18) zum Bereitstellen von Zwischenfrequenzsignalen empfängt,
- wobei mindestens eines der Elemente der Baugruppe gebildet wird:
• aus einem Bandpassfiltersystem (22), das konfiguriert, und betrieblich stromaufwärts des Mischers (20) in der Verarbeitungsrichtung der empfangenen Signale platziert ist, um die Funkfrequenzsignale entsprechend einer Bandbreite einer einstellbaren Frequenzbreite zu filtern, und
• einem Tiefpassfiltersystem (24), das konfiguriert, und betrieblich stromabwärts des Mischers (20) in der Verarbeitungsrichtung der empfangenen Signale platziert ist, um die Zwischenfrequenzsignale entsprechend einer Bandbreite einer einstellbaren Frequenzbreite zu filtern, und
- einen Detektor (28), der konfiguriert ist, um Daten in den Zwischenfrequenzsignalen zu detektieren, und
- Mittel (40) zum Speichern
wobei das Verfahren **dadurch gekennzeichnet ist, dass** die Mittel zum Speichern einen vorbestimmten Identifikationscode, einen Parameter einer Mindest-Oszillationsfrequenz eines lokalen Oszillators, einen Parameter einer maximalen Oszillationsfrequenz eines lokalen Oszillators, einen Parameter einer MindestFrequenzbreite einer Bandbreite und einen Parameter einer maximalen Frequenzbreite einer Bandbreite speichern, und dadurch, dass es ein Verfahren zum Einstellen (102, 110; 102, 110, 126, 132) der lokalen Frequenz des lokalen Oszillators (18) zwischen den minimalen und maximalen Oszillationsfrequenzen, und eine Einstellung (100, 114) der Bandbreite des Filtersystems (22, 24) zwischen den minimalen und maximalen Frequenzbreiten beinhaltet bis der Detektor (28) den vorbestimmten Identifikationscode in einem der Zwischenfrequenzsignale detektiert (104, 106).

8. Computerprogramm, das aus einem Kommunikationsnetzwerk herunterladbar ist, und/oder auf einem Support (40) gespeichert ist, der durch einen Computer lesbar ist, und/oder von einem Prozessor ausführbar ist, **dadurch gekennzeichnet, dass** es Anweisungen zur Ausführung eines Verfahrens zum Einstellen nach Anspruch 7 umfasst, wenn das Programm auf einem Prozessor (42) einer Empfangsvorrichtung (14) von Funkfrequenzsignalen ausgeführt wird.

## Claims

1. A radiofrequency receiver (14) device including:
- a local oscillator (18) oscillating at an adjustable local frequency,
- a mixer (20) receiving radiofrequency signals and the output of the local oscillator (18) for the supply of intermediate-frequency signals,
- at least one of the elements of the set consisting of:
• a band-pass filtering system (22), configured and placed functionally upstream from the mixer (20) in the direction of received signal processing to filter the radiofrequency signals according to a bandpass with an adjustable frequency bandwidth, and
• a low-pass filtering system (24), configured and placed functionally downstream from the mixer (20) in the direction of received signal processing to filter the intermediate-frequency signals according to a bandpass with an adjustable frequency bandwidth, and
- a detector (28) configured to detect data in the intermediate-frequency signals,
**characterized in that** it further includes:
- means (40) for storing a predetermined identification code, a minimum oscillation frequency parameter of local oscillator, a maximum oscillation frequency parameter of local oscillator, a minimum frequency bandwidth parameter and a maximum frequency bandwidth parameter, and
- means (42) for adjusting the local frequency of the local oscillator (18), between the minimum and maximum oscillation frequencies, and for adjusting the bandpath of the filtering system (22, 24) between the minimum and maximum frequency bandwidths, suitable for adjusting said local frequency and said bandpath until the detector (28) detects the predetermined identification code in one of the intermediate-frequency signals.

2. The radiofrequency receiver device (14) according to claim 1, including at least the band-pass filtering system and wherein the band-pass filtering system is controlled by the local oscillator so as to be centered about the adjustable local frequency.

3. The radiofrequency receiver device (14) according to claim 1 or 2, wherein the minimum frequency bandwidth parameter is defined such that this minimum frequency bandwidth is less than the difference between the minimum and maximum oscillation frequencies.

4. The radiofrequency receiver device (14) according to any of claims 1 to 3, including an adjustable gain amplifier (26), wherein:
- the storage means (40) store a minimum gain parameter and a maximum gain parameter, and
- the adjusting means (42) are further devised to adjust the gain of the amplifier (26), between the minimum and maximum gains, and suitable for adjusting this gain until the detector (28) detects the predetermined identification code in one of the intermediate-frequency signals.

5. The radiofrequency receiver device (14) according to any of claims 1 to 4, wherein the storage means (40) are conofigured to store at least one table of predefined parameters between at least the minimum local oscillation frequency parameter, the maximum local oscillation frequency parameter, the minimum frequency bandwidth parameter and the maximum frequency bandwidth parameter, along with at least one scroll policy of this parameter table.

6. A radiofrequency receiver system, including a main receiver device (12) and a secondary receiver device (14) of radiofrequency signals, wherein:
- the secondary receiver device (14) is programmed to be activated sporadically during predetermined cycles and is a radiofrequency receiver device as claimed in any of claims 1 to 5,
- the main receiver device (12) is suitable for activation by the secondary receiver device (14), and
- the secondary receiver device (14) is programmed to activate the main receiver device (12) on detection, by the detector (28) thereof, of the predetermined identification code.

7. A method for adjusting a radiofrequency reception device, for a device (14) including:
- a local oscillator (18) oscillating at an adjustable local frequency,
- a mixer (20) receiving the radiofrequency signals and the output of the local oscillator (18) for the supply of intermediate-frequency signals,
- at least one of the elements of the set consisting of:
• a band-pass filtering system (22), configured and placed functionally upstream from the mixer (20) in the direction of received signal processing to filter the radiofrequency signals according to a bandpass with an adjustable frequency bandwidth, and
• a low-pass filtering system (24), configured and placed functionally downstream from the mixer (20) in the direction of received signal processing to filter the intermediate-frequency signals according to a bandpass with an adjustable frequency bandwidth, and
- a detector (28) configured to detect data in the intermediate-frequency signals, and
- storing means (40),
wherein the method is **characterized in that**, the storing means store a predetermined identification code, a minimum oscillation frequency parameter of local oscillator, a maximum oscillation frequency parameter of local oscillator, a minimum frequency bandwidth parameter and a maximum frequency bandwidth parameter, and **in that** it includes a method for adjusting (102, 110; 102, 110, 126, 132) the local frequency of the local oscillator (18), between the minimum and maximum oscillation frequencies, and adjusting (100, 114) the bandpath of the filtering system (22, 24), between the minimum and maximum frequency bandwidths, until the detector (28) detects (104, 106) the predetermined identification code in one of the intermediate-frequency signals.

8. A computer program downloadable from a communication network and/or recorded on a computer-readable medium (40) and/or executable by a processor, **characterized in that** it comprises instructions for the execution of an adjusting method according to claim 7, when said program is executed on a processor (42) of a radiofrequency reception device (14).
